(19) Europäisches Patentamt
European Patent Office
Office européen des brevets

(11) Veröffentlichungsnummer: **0 496 229 A2**

(12) **EUROPÄISCHE PATENTANMELDUNG**

(21) Anmeldenummer: **92100392.7**

(22) Anmeldetag: **11.01.92**

(51) Int. Cl.5: **H01L 21/306**, H01L 21/311, H01L 21/321, C23F 1/16

(30) Priorität: **21.01.91 DE 4101564**

(43) Veröffentlichungstag der Anmeldung: **29.07.92 Patentblatt 92/31**

(84) Benannte Vertragsstaaten: **DE FR GB IT**

(71) Anmelder: **RIEDEL-DE HAEN AKTIENGESELLSCHAFT**
**Wunstorfer Strasse 40**
**W-3016 Seelze 1(DE)**

(72) Erfinder: **Leifels, Joachim**
**Südfeld 4**
**W-3007 Gehrden(DE)**
Erfinder: **Sievert, Wolfgang, Dr.**
**Dresdner Strasse 10**
**W-3050 Wunstorf-Kolenfeld(DE)**

(74) Vertreter: **Urbach, Hans-Georg, Dr. et al**
**CASSELLA AKTIENGESELLSCHAFT**
**Patentabteilung Hanauer Landstrasse 526**
**W-6000 Frankfurt am Main 60(DE)**

(54) **Ätzlösung für nasschemische Prozesse der Halbleiterherstellung.**

(57) Die vorliegende Erfindung betrifft eine Ätzlösung auf Basis Flußsäure oder Phosphorsäure/Salpetersäure, dadurch gekennzeichnet, daß sie als Additiv eine oder mehrere der Verbindungen der allgemeinen Formel I

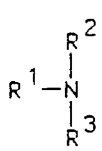

(I)

worin $R^1$ $(C_6\text{-}C_{18})$-Alkyl und
$R^2$ und $R^3$ unabhängig voneinander Wasserstoff oder $(C_1\text{-}C_5)$-Alkyl bedeutet
oder eine oder mehrere der Verbindungen der allgemeinen Formel II

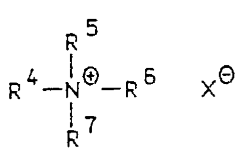

(II)

worin $R^4$ $(C_6\text{-}C_{18})$-Alkyl,
$R^5$ bis $R^7$ unabhängig voneinander $(C_1\text{-}C_5)$-Alkyl und
X Fluorid im Falle einer Flußsäurelösung und Phosphat bzw. Nitrat im Falle einer Phosphorsäure/Salpetersäurelösung bedeutet, enthält.

EP 0 496 229 A2

Die vorliegende Erfindung betrifft eine Ätzlösung für naßchemische Prozesse der Halbleiterherstellung, die Flußsäure oder Phosphorsäure/Salpetersäure sowie ein Additiv enthält.

Zur Herstellung von diskreten oder integrierten elektronischen Bauelementen auf Siliziumbasis werden in den verschiedensten Herstellungsschritten naßchemische Prozesse eingesetzte. Diese lassen sich grob in naßchemische Reinigungsschritte und naßchemische Strukturierungsschritte einteilen.

Bei den Reinigungsschritten, insbesondere aber bei den Strukturierungsschritten ist es außerordentlich wichtig, daß die Oberflächenspannung der Reinigungs- bzw. Ätzflüssigkeit möglichst gering ist und die zu reinigenden bzw. zu ätzenden Oberflächen ausreichend benetzt werden.

Zu ätzende Schichten sind beispielsweise auf Siliziumscheiben aufgebrachte Aluminiumschichten. Zu deren Strukturierung werden fotochemisch aktive organische Schichten (Fotolacke) auf die Siliziumscheiben aufgesponnen und nach Belichtung des Fotolacks durch Entwicklung strukturiert. Diese strukturierten Lackschichten dienen im nachfolgenden Ätzschritt zur Maskierung der Ätzung in den belackten Gebieten, während die freientwickelten Gebiete weggeätzt werden. Die Fotolackstrukturen bilden dabei oft nur 1 µm breite und 0,5 bis 2 µm hohe Erhebungen über den Aluminiumschichten. Beim Eintauchen der Scheibe in die Ätzlösung müssen die in diesen Strukturen haftenden Luftschichten verdrängt werden, da diese die Ätzung maskieren und damit Defekte in den Bauelementen erzeugen würden. Es ist deshalb besonders wesentlich, daß die Ätzlösung die Oberfläche gut benetzt und eine geringe Oberflächenspannung besitzt. Ist nur die Benetzung gut oder nur die Oberflächenspannung erniedrigt, lösen sich die Lufteinschlüsse nicht von der Oberfläche ab.

Weit verbreitete Ätzmittel sind beispielsweise Phosphorsäure/Salpetersäure-Mischungen, denen zur Verbesserung ihrer Eigenschaften Additive zugegeben werden. Geeignete Additive müssen die Oberflächenspannung auf einen Wert kleiner 30 mN/m herabsetzen und für eine gute Benetzung der zu ätzenden Oberflächen bzw. der die Ätzung maskierenden Fotolackschichten sorgen. Weiter muß das Additiv in der Ätzlosung gut löslich sein und damit deren Stabilität gegenüber Kreislauffiltration gewährleisten. Es darf keine metallischen Verunreinigungen, die über die üblichen Gehalte der Chemikalien in Halbleiterprozessen hinausgehen, enthalten und es darf keine Reaktion mit der zu ätzenden Oberfläche (Chemisorption) zeigen. Bei der Ätzung darf sich das Additiv nicht an der ätzenden Grenzfläche abscheiden und schließlich muß es sich nach der Ätzung durch die üblichen Spülprozesse von der Oberfläche wieder entfernen lassen.

Bekannte Additive für Phosphorsäure/Salpetersäure-Mischungen sind beispielsweise teilweise oder vollständig fluorierte aliphatische Carbonsäuren oder Sulfonsäuren bzw. deren Salze (Shak et al. Semiconductor International, Oktober 1988 Seiten 132-134). Diese Additive verbessern jedoch nicht die Benetzung, so daß kein Einfluß auf das Ablösen der Lufteinschlüsse aus den zu ätzenden Gebieten zu beobachten ist. Außerdem sind sie nicht stabil gegenüber Kreislauffiltration und werden im Filter abgeschieden. Für ein weiteres verbreitetes Ätzmittel, Flußsäurelösungen, sind bisher keine Additive bekannt. Allerdings sind als Additive für Ammoniumfluorid/Flußsäure-Mischungen aliphatische primäre Amine einsetzbar (Kikuyama et. al, Microcontamination, April 1989, Seiten 25-51).

Insgesamt kann gesagt werden, daß Ätzlösungen auf Basis Flußsäure und Phosphorsäure/Salpetersäure bisher nicht optimal sind und somit nur eingeschränkt eingesetzt werden können. Dies gilt um so mehr, als zukünftig als Ergebnis der Technologieentwicklung noch kleinere Strukturen auftreten werden und damit die Ätzlösungen des Standes der Technik noch weniger den Anforderungen gerecht werden.

Aufgabe der vorliegenden Erfindung ist es, uneingeschränkt einsetzbare Ätzlösungen bereitzustellen.

Diese Aufgabe wird gelöst durch Ätzlösungen auf Basis Flußsäure oder Phosphorsäure/Salpetersäure, dadurch gekennzeichnet, daß sie als Additiv eine oder mehrere der Verbindungen der allgemeinen Formel I

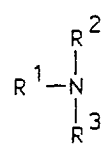

(I)

worin $R^1$ $(C_6\text{-}C_{18})$-Alkyl und
$R^2$ und $R^3$ unabhängig voneinander Wasserstoff oder $(C_1\text{-}C_5)$-Alkyl bedeutet
oder eine oder mehrere der Verbindungen der allgemeinen Formel II

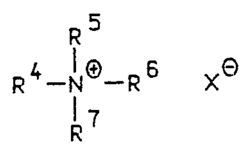

(II)

worin $R^4$ $(C_6\text{-}C_{18})$-Alkyl,
$R^5$ bis $R^7$ unabhängig voneinander $(C_1\text{-}C_5)$-Alkyl und X Fluorid im Falle einer Flußsäurelösung und

Phosphat bzw. Nitrat im Falle einer Phosphorsäure/Salpetersäure-Lösung bedeutet, enthält.

$R^1$ und $R^4$ bedeuten bevorzugt ($C_8$-$C_{14}$)-Alkyl, $R^2$, $R^3$ sowie $R^5$ bis $R^7$ bevorzugt Methyl und Ethyl.
Bevorzugte Verbindungen der allgemeinen Formel I sind Nonylamin, Dodecylamin, Methyldecylamin und Dimethyltetradecylamin.

Eine bevorzugte Verbindung der allgemeinen Formel II ist Trimethyldodecylammoniumfluorid bzw. -phosphat.

Die Verbindungen der allgemeinen Formel I bzw. II sind in den erfindungsgemäßen Ätzlösungen bevorzugt in Mengen von mindestens 10 ppm enthalten. Besonders bevorzugt sind sie in Mengen von 100 bis 600 ppm enthalten.

Erfindungsgemäße Ätzlösungen auf Basis Flußsäure sind wäßrige Lösungen und enthalten Flußsäure bevorzugt in Mengen von 0,1 bis 50 Gew.%, besonders bevorzugt in Mengen von 0,5 bis 5 Gew.%.

Erfindungsgemäße Ätzlösungen auf Basis Phosphorsäure/Salpetersäure sind ebenfalls wäßrige Lösungen und enthalten Phosphorsäure bevorzugt in Mengen von 20 bis 80 Gew.%, besonders bevorzugt 60 bis 80 Gew.% und Salpetersäure bevorzugt in Mengen von 0,1 bis 10 Gew.%, besonders bevorzugt 1 bis 3 Gew.%.

Die erfindungsgemäßen Ätzlösungen können in einfacher Weise durch Mischen der Bestandteile hergestellt werden. Im Falle von Ätzlösungen auf Basis Flußsäure können die Verbindungen der allgemeinen Formel I dabei auch in Form ihrer Hydrofluoride eingesetzt werden.

Die erfindungsgemäßen Flußsäure- bzw. Phosphorsäure/Salpetersäure-Lösungen können uneingeschränkt in Halbleiterherstellungsprozessen zur Ätzung von Siliziumoxidschichten bzw. fotolackbeschichteten Aluminiumschichten eingesetzt werden und zwar sowohl in Bad- als auch in Sprühprozessen. Sie benetzen die Oberflächen in ausgezeichneter Weise, ihre Oberflächenspannung liegt unter 30 mN/m und es kommt zu keinen Abscheidungen des Additivs während des Ätzvorgangs. Insbesondere führen die erfindungsgemäßen Ätzlösungen auch zu einer Verminderung der auf der Oberfläche abgeschiedenen Partikel in den Reinigungs- bzw. Ätzprozessen.

Bei der Strukturierung von fotolackbeschichteten Aluminiumschichten mit Phosphorsäure/Salpetersäure können der beim Ätzen entstehende Wasserstoff ebenso wie die beim Beginn der Ätzung vorhandenen Lufteinschlüsse, ebenso wie bei der Ätzung mit Flußsäure leicht von der Oberfläche abgelöst werden. Dadurch kann der Gesamtprozeß bezüglich der Homogenität der Ätzrate wesentlich verbessert, das heißt beispielsweise die Ätzzeit verkürzt werden. Dies ist deshalb von Bedeutung, da die Ätzung nicht nur wie gewünscht vertikal zur Oberfläche abläuft, sondern auch lateral unter die maskierenden Fotolackschichten. Diese lateralen Ätzungen müssen so klein wie möglich gehalten werden, d.h. Überätzungen müssen möglichst verhindert werden.

Beispiel 1

Eine Siliziumoberfläche wurde mit einer Ätzlösung aus 50%iger Flußsäure und 250 ppm Trimethyldodecylammoniumfluorid, die eine Oberflächenspannung von 30 mN/m aufwies, bearbeitet. Die Oberfläche wurde vollständig benetzt und es resultierte eine Ätzung gewünschter Qualität.

Zum Vergleich wurde eine Siliziumoberfläche mit 50%iger Flußsäure ohne Additiv bearbeitet. Die Oberflächenspannung der Lösung betrug 85 mN/m. Die Oberfläche zeigte außer kleinen anhaftenden Flußsäuretropfen keinerlei Benetzung. Eine Ätzung der erforderlichen Qualität wurde nicht erhalten.

Beispiel 2

Eine Aluminiumschicht mit einer strukturierten Fotolackschicht wurde mit einer Ätzlösung mit einem Gehalt von 74 Gew.% Phosphorsäure, 2,5 Gew.% Salpetersäure und 200 ppm Dodecylamin mit einer Ätzzeit von 4 Minuten und 40 Sekunden bearbeitet. Die Oberfläche wurde vollständig benetzt und es resultierte eine Ätzung von hervorragender Homogenität, bei der keine Aluminiumrückstände zu beobachten waren.

Zum Vergleich wurde die Ätzung wiederholt, allerdings mit einer Ätzlösung ohne Additiv. Die Oberfläche zeigte nur eine geringe Benetzung und die Ätzlösung konnte bei senkrechter Stellung der Oberfläche leicht ablaufen. Die Ätzung war äußerst inhomogen und führte zu Ätzfehlern aufgrund von Aluminiumrückständen.

**Patentansprüche**

**1.** Ätzlösung auf Basis Flußsäure oder Phosphorsäure/Salpetersäure, dadurch gekennzeichnet, daß sie als Additiv eine oder mehrere der Verbindungen der allgemeinen Formel I

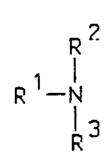

(I)

worin $R^1$ ($C_6$-$C_{18}$)-Alkyl und $R^2$ und $R^3$ unabhängig voneinander Wasserstoff oder ($C_1$-$C_5$)-Alkyl bedeutet oder eine oder mehrere der Verbindungen der allgemeinen Formel II

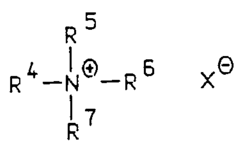

(II)

worin $R^4$ ($C_6$-$C_{18}$)-Alkyl, $R^5$ bis $R^7$ unabhängig voneinander ($C_1$-$C_5$)-Alkyl und X Fluorid im Falle einer Flußsäurelösung und Phosphat bzw. Nitrat im Falle einer Phosphorsäure/Salpetersäure-Lösung bedeutet, enthält.

**2.** Ätzlösung nach Anspruch 1, dadurch gekennzeichnet, daß sie das Additiv der allgemeinen Formel I bzw. II in Mengen von mindestens 10 ppm, bevorzugt 100 bis 600 ppm enthält.

**3.** Ätzlösung nach Anspruch 1 und/oder 2, dadurch gekennzeichnet, daß sie Flußsäure in Mengen von 0,1 bis 50 Gew.%, bevorzugt 0,5 bis 5 Gew.%, enthält.

**4.** Ätzlösung nach Anspruch 1 und/oder 2, dadurch gekennzeichnet, daß sie Phosphorsäure in Mengen von 20 bis 80 Gew.%, bevorzugt 60 bis 80 Gew.% und Salpetersäure in Mengen von 0,1 bis 10 Gew.%, bevorzugt 1 bis 3 Gew.%, enthält.

**5.** Verwendung der Ätzlösungen der Ansprüche 1 bis 4 zur Ätzung von Siliziumoxidschichten oder fotolackbeschichteten Aluminiumschichten.